(19) Europäisches Patentamt
European Patent Office
Office européen des brevets

(11) EP 3 595 420 B1

(12) EUROPEAN PATENT SPECIFICATION

(45) Date of publication and mention of the grant of the patent:
**16.12.2020 Bulletin 2020/51**

(51) Int Cl.:
*H05K 7/20* (2006.01) *H05K 9/00* (2006.01)
*H01L 23/373* (2006.01)

(21) Application number: **19185414.0**

(22) Date of filing: **10.07.2019**

(54) **THERMALLY CONDUCTIVE COMPOSITION**

WÄRMELEITFÄHIGE ZUSAMMENSETZUNG

COMPOSITION THERMOCONDUCTRICE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **11.07.2018 JP 2018131905**

(43) Date of publication of application:
**15.01.2020 Bulletin 2020/03**

(73) Proprietor: **Kitagawa Industries Co., Ltd.**
**Inazawa-shi, Aichi 492-8446 (JP)**

(72) Inventors:
- **MITSUYA, Kensuke**
  **Kasugai-shi, Aichi 4800303 (JP)**
- **KAWAGUCHI, Yasuhiro**
  **Kasugai-shi, Aichi 4800303 (JP)**
- **SAITO, Masahiro**
  **Kasugai-shi, Aichi 4800303 (JP)**
- **MATSUZAKI, Toru**
  **Kasugai-shi, Aichi 4800303 (JP)**
- **ITO, Masaaki**
  **Suwa-shi, Nagano 3920001 (JP)**
- **OMORI, Toshiyuki**
  **Suwa-shi, Nagano 3920001 (JP)**

(74) Representative: **Grünecker Patent- und Rechtsanwälte**
**PartG mbB**
**Leopoldstraße 4**
**80802 München (DE)**

(56) References cited:
**EP-A1- 0 508 266**
**EP-A2- 0 528 606**
**WO-A1-2007/060746**
**WO-A1-2017/116656**
**US-A1- 2012 228 018**
**US-A1- 2017 271 040**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 595 420 B1

## Description

### BACKGROUND OF THE INVENTION

#### 1. Field of the Invention

The present invention relates to a thermally conductive composition for promoting heat dissipation from a heat source, for example, an electronic component.

#### 2. Description of the Related Art

US 2012/228018 A1 relates to a method of making an electromagnetic interference (EMI) absorber, the EMI absorber comprising a material stretched along at least an axis and that includes EMI absorbing particles, at least some of which are aligned generally parallel with said axis.
EP 0 528 606 A2 relates to a thermally conductive interface material formed of a polymeric binder and one or more thermally fillers.
WO 2007/060746 A1 relates to an EMI suppressor.
EP 0 508 266 A1 relates to a semiconductor device having a die stress.
WO 2017/116656 A1 relates to an EMI shielding article.
US 2017/271040 A1 relates to an EMI mitigating material.
Conventionally, a thermally conductive composition, for example, a thermally conductive sheet that is excellent in thermal conductivity has been manufactured. The thermally conductive composition, for example, a thermally conductive sheet is utilized so as to efficiently transfer heat (dissipate heat) from a heat source to a radiator when sandwiched between the heat source and the radiator, the heat source being an electronic component or the like, the radiator being a heat sink or the like. In general, the thermally conductive composition has a composition containing micro-size or nano-size material with high thermal conductivity (hereinafter referred to as thermally conductive filler), for example, insulating ceramics such as alumina as a major part thereof to increase thermal conductivity (thermal conductance).
However, a thermally conductive composition, for example, a thermally conductive sheet containing only a conventional thermally conductive filler can cope with heat generation by an electronic component such as an IC (integrated circuit) or the like, but cannot suppress (absorb) electromagnetic wave (noise) generated by such an electronic component. This problem is caused by the following phenomenon. When a metal body having electrical conductivity is present in the vicinity of an electronic component such as an IC or the like, that generates electromagnetic wave, the electromagnetic wave emitted from the IC or the like is transferred to the metal body. It is generally known that the metal body causes a resonance phenomenon in accordance with the size of the metal body and the frequency of the transferred electromagnetic wave, thereby the metal body serves as a kind of antenna, and emits therefrom electromagnetic wave stronger than the electromagnetic wave emitted from the electronic component.
A radiator generally comprises a metal body made of aluminum or the like and is placed in the vicinity of an IC or the like, so that the problem related to electromagnetic wave described above has occurred. In addition, if a thermally conductive sheet having a dielectric constant (permittivity) higher than that of air is interposed between an IC or the like and a metal body, the resonance frequency of the metal body shifts to a lower frequency than in the case where air is present between the IC and the metal body. Furthermore, if a material having a high dielectric constant is present between an IC or the like and a radiator, electrostatic capacitance becomes large, and electromagnetic wave emitted from the IC or the like is more efficiently propagated to the radiator. As a result, the electromagnetic wave emitted from the radiator becomes even stronger. In recent years, there have been thermally conductive sheets which use a thermally conductive filler containing carbon or the like in order to increase thermal conductivity. Carbon has a very high dielectric constant and makes the electric field strength of the electromagnetic wave emitted from the radiator high, and it is therefore difficult to solve the problem. Hereinafter resonance means that the impedance changes extremely at a specific frequency. The voltage or current changes as the impedance changes, and therefore resonance is a factor facilitating electromagnetic interference.
A thermally conductive electromagnetic wave absorbing sheet has been known, in which a thermally conductive sheet contains a magnetic filler (high magnetic permeability filler) such as ferrite or the like, that is configured so as to absorb electromagnetic wave generated by an electronic component such as an IC or the like by covering the electronic component (for example, refer to Japanese Laid-open Patent Publication 2016-92118). With the thermally conductive sheet containing the magnetic filler such as ferrite or the like, it is possible to suppress electromagnetic wave particularly in the high frequency range among the electromagnetic wave generated by resonating the radiator with the electromagnetic wave generated from the above-described electronic component.
However, the thermally conductive sheet containing magnetic filler such as ferrite or the like, described in Japanese Laid-open Patent Publication 2016-92118 makes it difficult to suppress electromagnetic wave in a relatively low frequency range, for example, lower than 1 GHz, although it can suppress electromagnetic wave in a relatively high frequency range, for example, a frequency range of 1 GHz or higher. The reason for this is as follows. The thermally conductive sheet containing the magnetic filler obtains a high dielectric constant by only containing the magnetic filler, and makes the resonance frequency of the metal body serving as the radiator shifted to the lower frequency side. In addition, as the dielectric constant becomes higher, the shift width of the resonance frequency to the lower frequency side becomes wider. Thus, the thermally conductive sheet only containing the magnetic filler makes the first (lowest) resonance frequency largely shifted to the lower frequency side, thereby increasing the electric field strength of the electromagnetic wave lower than or equal to the resonance frequency after the shift. For example, if the length of one side of the radiator is about 100 mm and there is no thermally conductive sheet, the first resonance frequency is around 1.2 GHz. In the lower frequency range, that is, the frequency range about 1 GHz or lower, according to the above principle, the higher the dielectric constant, the electric field strength from the radiator is high. In brief, the thermally conductive sheet only containing the magnetic filler cannot suppress electromagnetic wave in the relatively lower frequency range (for example, the frequency range lower than 1 GHz). On the contrary, the electric field strength of the electromagnetic wave is greatly increased.

## BRIEF SUMMARY OF THE INVENTION

The present invention solves the above-described problem, and an object of the present invention is to provide a thermally conductive composition which can suppress electromagnetic wave regardless of frequency range.

This object is achieved by a thermally conductive composition as defined in claim 1.

The present invention uses high magnetic permeability filler so that the relative magnetic permeability of the thermally conductive composition is higher than 1, so that electromagnetic wave in the high frequency range higher than about 1 GHz can be suppressed similarly to a thermally conductive composition, for example, a thermally conductive sheet containing conventional magnetic filler such as ferrite or the like. In addition, the relative dielectric constant in the entire thermally conductive composition is decreased to 7 or lower by the internally provided air region (having a relative dielectric constant of approximately 1). Thus, the thermally conductive composition sandwiched between an electronic component such as an IC or the like and a radiator such as a heat sink reduces the electrostatic capacitance between the electronic component such as an IC or the like and the radiator, so that the electromagnetic wave emitted from the electronic component such as an IC or the like is less likely to propagate to the radiator. Therefore, it is possible to reduce electromagnetic wave emitted from the radiator. Furthermore, as described above, by setting the relative dielectric constant in the thermally conductive composition to a low value of 7 or lower, the effect in suppressing the electromagnetic wave particularly in a relatively low frequency range (for example, the frequency range lower than 1 GHz) can be increased.

The reason is as follows. In general, as the relative dielectric constant of a thermally conductive composition sandwiched between an electronic component such as IC or the like and a radiator becomes higher, the resonance frequency of the radiator shifts to the lower frequency side. Accordingly, in the above-described relatively low frequency range, the electric field strength of the electromagnetic wave from the radiator becomes higher as the dielectric constant of the thermally conductive composition becomes higher. By contrast, in the thermally conductive composition of the present invention, as described above, by setting the relative dielectric constant to a low value of 7 or lower, the resonance frequency of the radiator can be shifted to the higher frequency side. As a result, the effect in suppressing electromagnetic wave in a relatively low frequency range (for example, the frequency range lower than 1 GHz) can be increased. Thus, with the thermally conductive composition of the present invention, it is possible to suppress electromagnetic wave regardless of frequency ranges (in either the high frequency range or the low frequency range). In addition, with the thermally conductive composition of the present invention, the weight of the entire thermally conductive composition can be reduced by having the air region inside.

The thermally conductive composition may further comprise a dielectric constant adjustment filler having a dielectric constant lower than that of the base material.

In the thermally conductive composition, it is preferable that the dielectric constant adjustment filler comprises an in-filler air region inside or be a material selected from the group consisting of boron nitride and silica.

In the thermally conductive composition, the high permeability filler may have an air region inside.

While the novel features of the present invention are set forth in the appended claims, the present invention will be better understood from the following detailed description taken in conjunction with the drawings.

## BRIEF DESCRIPTION OF THE DRAWINGS

The present invention will be described hereinafter with reference to the annexed drawings. Embodiments and drawings with the air region perforating the base material are not according to the invention and are present for illustration purposes only.

It is to be noted that the drawings are shown for the purpose of illustrating the technical concepts of the present invention or embodiments thereof, wherein:

FIG. 1 is a schematic cross-sectional view of a thermally conductive sheet as a thermally conductive composition according to an embodiment of the present invention;
FIG. 2 is a schematic cross-sectional view of members around the thermally conductive sheet for explaining how to use the thermally conductive sheet;
FIGs. 3A to 3E are schematic top views of samples of the thermally conductive sheets for relative dielectric constant measurement with zero to four holes, respectively;
FIG. 4 is a graph showing the measurement results of the relative dielectric constant using the above-described samples of the thermally conductive sheets for relative dielectric constant measurement;
FIG. 5 is a schematic top view of a sample of the thermally conductive sheet for relative magnetic permeability measurement;
FIG. 6 is a graph showing the measurement results of the relative magnetic permeability using the above-described samples of thermally conductive sheets for relative magnetic permeability measurement;
FIG. 7 is a schematic top view of a sample of the thermally conductive sheet for thermal resistance measurement;
FIG. 8 is a graph showing the measurement results of thermal resistance using the above-described sample of thermally conductive sheet for thermal resistance measurement;

## DETAILED DESCRIPTION OF THE INVENTION

The following describes a thermally conductive composition according to an embodiment of the present invention with reference to the drawings. In the present embodiment, an example in which the thermally conductive composition is a thermally conductive sheet is described.

Embodiments and drawings with the air region perforating the base material are not according to the invention and are present for illustration purposes only.

(Material of Thermally conductive Sheet)

FIG. 1 is a schematic cross-sectional view showing the structure of a thermally conductive sheet according to the present embodiment. As shown in FIG. 1, the thermally conductive sheet 1 comprises a base material 2, and a high magnetic permeability filler 3 having a magnetic permeability higher than that of the base material 2. In addition, the thermally conductive sheet 1 comprises an air region inside (the inside of the base material 2). This air region may be an air layer provided inside (but not perforating) the base material 2. With the high magnetic permeability filler 3, the thermally conductive sheet 1 increases the relative magnetic permeability of the entire thermally conductive sheet 1 so that the relative magnetic permeability is higher than 1. Furthermore, in the thermally conductive sheet 1, as described above, by providing the air region inside (the inside of the base material 2), the air region being filled with air having a relative dielectric constant of substantially 1, the relative dielectric constant of the entire thermally conductive sheet 1 is decreased to lower than or equal to 7. In the following description, it should be noted that porosity means the ratio of the volume of the air region in the volume of the entire thermally conductive sheet 1.

As the base material 2, for example, an acrylic resin such as an acrylic polymer, a silicone resin, and other general resins can be used suitably. The acrylic polymer is obtained by polymerizing or copolymerizing an acrylic group resin containing a (meth)acrylic acid ester and a polymer that has been obtained by polymerizing a monomer containing a (meth)acrylic acid ester.

Examples of the high magnetic permeability filler 3 mentioned above may contain filler made of metal oxide, for example, soft ferrite or the like. Hereinafter soft ferrite means ferrite (a generic term for ceramics containing iron oxide as a main ingredient), that exhibits soft magnetism. Using the high magnetic permeability filler 3 can increase the relative magnetic permeability of the thermally conductive sheet 1. In addition, as described above, by increasing the relative magnetic permeability of the thermally conductive sheet 1 with the high magnetic permeability filler 3, the relative magnetic permeability of the thermally conductive sheet 1 can have an imaginary part ($\mu$"). When the imaginary part is present, a part of the energy of electromagnetic wave is converted to heat, so that the effect in suppressing the electromagnetic wave can be enhanced.

The thermally conductive sheet 1 of the present embodiment may comprise the dielectric constant adjustment filler having a dielectric constant lower than that of the base material 2. The above-described dielectric constant adjustment filler may be filler having an air region inside (hereinafter referred to as "hollow filler"), or may be a material selected from the group consisting of boron nitride and silica (silicon dioxide ($SiO_2$) or generic name of materials containing silicon dioxide) or the like. Examples of the above-described hollow filler include organic balloons such as acrylic balloon, perlite balloon, fly ash balloon, Shirasu balloon, glass balloon, and so on. Here, the perlite balloon is an artificial foam obtained by heat treating perlite ore produced as volcanic rock, diatomaceous earth or the like at high temperature. When the hollow filler is contained as dielectric constant adjustment filler, the dielectric constant of the thermally conductive sheet 1 can be decreased because the hollow filler contains gas inside, thereby having a low relative dielectric constant.

Using (containing) the dielectric constant adjustment filler can suppress the porosity of the air region than in the case where the relative dielectric constant is decreased with only the air region in the base material 2, and can decrease the relative dielectric constant of the entire thermally conductive sheet 1 to lower than or equal to 7.

In the thermally conductive sheet 1 of the present embodiment, the high magnetic permeability filler 3 may be hollow filler having an air region inside. In this configuration, the high magnetic permeability filler 3 can also function as the dielectric constant adjustment filler (can function to decrease the dielectric constant). Therefore, as in the case of using the above-described dielectric constant adjustment filler, the porosity of the air region in the base material 2 can be suppressed and the relative dielectric constant of the entire thermally conductive sheet 1 can be decreased to 7 or lower. Furthermore, both the dielectric constant adjustment filler and the high magnetic permeability filler 3 may be hollow filler having an air region inside. Also in this configuration, it is possible to suppress the porosity of the air region inside the base material 2 and decrease the relative dielectric constant of the entire thermally conductive sheet 1 to 7 or lower.

The thermally conductive sheet 1 of the present embodiment may contain filler for adjusting thermal conductivity (hereinafter referred to as "thermally conductive filler") and filler for adjusting viscosity (hereinafter referred to as "viscosity adjustment filler") in addition to the high magnetic permeability filler 3. Examples of the thermally conductive filler include alumina, silicon carbide, and magnesium hydroxide and so on in addition to inexpensive aluminum hydroxide. Boron nitride may be used as both the dielectric constant adjustment filler and the thermally conductive filler. When the thermally conductive sheet 1 contains the thermally conductive filler, the thermal conductivity of the entire thermally conductive sheet 1 can be made higher than that of the base material 2. As described above, by increasing the thermal conductivity of the thermally conductive sheet 1, heat is less likely to be accumulated in the heat source such as an electronic device or the like in contact with the thermally conductive sheet 1. Because the thermally conductive sheet 1 makes heat less likely to be accumulated in a heat source such as an electronic device or the like, effects in improving thermal resistance and durability can be obtained. Furthermore, depending on the material of the heat source, its thermal expansion can be reduced, so that its distortion can be reduced. There are other effects. Because heat is less likely to be accumulated, the progress of chemical deterioration (or corrosion) can be suppressed and a device user can.be prevented from accidents such as low temperature burn injury and the like.

Examples of the viscosity adjustment filler include magnesium hydroxide that is also a thermally conductive filler, and so on. The viscosity of the entire thermally conductive sheet 1 can be increased when the thermally conductive sheet 1 contains viscosity adjustment filler such as magnesium hydroxide or the like. By increasing the viscosity of the entire thermally conductive sheet, separation of the filler contained in the sheet can be suppressed. In addition, because the flowability is not unnecessarily high, the dimensional stability in forming a sheet can be improved, and as a result, the yield rate (non-defective rate) can be improved.

(Method of Manufacturing Thermally conductive Sheet)

Next, an example of a method of manufacturing the thermally conductive sheet 1 is described. First, an ingredient for a base material 2 such as an acrylic resin is mixed and kneaded with fillers such as a permittivity adjusting filler 3 and so on to make a thermally conductive material in which various types of filler are homogeneously dispersed in the base material 2. Then, the thermally conductive material is formed into a sheet, and air regions, are provided in the sheet of the thermally conductive material by cutting or other processing, whereby the thermally conductive sheet 1 can be obtained. By forming the thermally conductive material 1 into a sheet, the thermally conductive material 1 more easily follows fine irregularities on the surfaces of a heat source and a radiator, and the contact thermal resistance with the heat source and the radiator can be decreased. In addition, the thermally conductive material 1 has an effect in improving the workability of attaching the thermally conductive sheet 1 to the heat source and the radiator, and an effect in reducing a load on the object to which the thermally conductive sheet 1 is attached.

Applicable methods of mixing described above are a kneading method using a machine such as a vacuum defoaming mixer, and various other methods using, for example, an extrusion kneader, a two roll, a kneader, a Banbury mixer and so on.

Applicable methods of forming described above are forming methods using a machine such as a coater, a calendar roll, an extrusion kneader, a press and so on. Among these methods, the method of forming with a coater is preferred because thin sheets can be easily manufactured, the method has high productivity, therefore being suitable for mass production, and the sheet thickness is easily made to be accurate.

(Example of Using of Thermally Conductive Sheet)

Next, an example of using of the thermally conductive sheet 1 of the present embodiment will be described with reference to FIG. 2. As shown in FIG. 2, the thermally conductive sheet 1 is sandwiched between a heat sink 12 and an integrated circuit (IC) 11 such as a micro-processing unit (MPU) or the like to be used. By using the thermally conductive sheet 1 in this manner, the upper surface of the thermally conductive sheet 1 can be in contact with the lower surface of heat sink 12 and the lower surface of thermally conductive sheet 1 can be in contact with the upper surface of IC 11 (see FIG. 2). Therefore, the thermally conductive sheet 1 can efficiently dissipate the heat from the IC 11 serving as the heat source to the heat sink 12. In FIG. 2, the IC 11 is mounted on a printed circuit board 13, and the lowermost layer in the printed circuit board 13 forms a ground layer 14.

Using the conventional thermally conductive sheet in the above-described manner causes the problem that the heat sink resonates with the electromagnetic wave generated by the IC and acts as a kind of antenna to generate stronger electromagnetic wave. By contrast, the thermally conductive sheet 1 according to the present embodiment uses the high magnetic permeability filler 3, so that the relative magnetic permeability of the entire thermally conductive sheet 1 is higher than 1, so that electromagnetic wave in the high frequency range higher than about 1 GHz can be suppressed. Furthermore, with the thermally conductive sheet 1, the relative dielectric constant of the entire thermally conductive sheet 1 is decreased to 7 or lower in the air region (having a relative dielectric constant of approximately 1) provided inside. The thermally conductive sheet 1 sandwiched between the IC 11 and the heat sink 12 reduces the electrostatic capacitance between the IC 11 and the heat sink 12, so that the electromagnetic wave emitted from the IC 11 is less likely to propagate to the heat sink 12, thereby suppressing electromagnetic wave radiated from the heat sink 12.

Furthermore, as described above, by setting the relative dielectric constant in the entire thermally conductive sheet 1 to a low value of 7 or lower, the effect in suppressing the electromagnetic wave particularly in the relatively low frequency range (for example, the frequency range lower than 1 GHz) can be increased. The reason is as follows. In general, as the relative dielectric constant of the thermally conductive sheet 1 sandwiched between the IC 11 and the heat sink 12 becomes higher, the resonance frequency of the heat sink 12 shifts to the lower frequency side. Accordingly, in the above-described relatively low frequency range, the electric field strength of the electromagnetic wave from the heat sink 12 becomes higher as the dielectric constant becomes higher. By contrast, in the thermally conductive sheet 1 of the present invention, as described above, by setting the relative dielectric constant to a low value of 7 or lower, the resonance frequency of the heat sink 12 can be shifted to the higher frequency side. As a result, the effect in suppressing electromagnetic wave in the relatively low frequency range (for example, the frequency range lower than 1 GHz) can be increased. Thus, with the thermally conductive sheet 1 of the present embodiment, it is possible to suppress electromagnetic wave regardless of frequency range (in either the high frequency range or the low frequency range). In addition, with the thermally conductive sheet 1 of the present embodiment, the weight of the entire thermally conductive sheet 1 can be reduced by having the air region inside.

<EXAMPLES>

The examples with an air region perforating the base material are not according to the invention and are present for illustration purposes only.

The following describes the above-described thermally conductive sheet 1 in more detail with a test example.

(Preparation of Sheet as Material of Samples for Various Measurements)

The applicant added two types of Ni-Zn-based soft ferrite materials as the high magnetic permeability filler 3 having different particle sizes, aluminum hydroxide as the thermally conductive filler, and magnesium hydroxide as the viscosity adjustment filler to a general-purpose acrylic polymer as the base material 2. These materials were kneaded with a vacuum degassing mixer and then formed with a coater to produce a sheet of 1 mm in thickness (hereinafter referred to as "sheet from which samples are cut out"). In addition, additives including an antioxidant, a crosslinking agent, and a polyfunctional monomer were also added to this sheet.

(Measurement of Relative Dielectric Constant)

A disc-shaped sheet 21 having a diameter of 7 mm and a thickness of 1 mm shown in FIG. 3A was cut out from the sheet created in the above-described manner and having a thickness of 1 mm. Then, with a punch for perforating, one to four holes 4 each having a diameter of 1.4 mm in actual measurement average were opened in the respective disc-shaped sheets 21 as shown in FIGs. 3B to 3E. In this manner, the porosity of each disk-shaped sheet 21 was changed (increased), and the relative dielectric constant ε' of each sample shown in FIGs. 3A to 3E was measured. The measurement results are shown in Table 1 and FIG. 4. In FIGs. 3C to 3E, the distance between the holes was substantially the same.

TABLE 1

| Number of Holes | 0 | 1 | 2 | 3 4 | |
|---|---|---|---|---|---|
| Porosity [vol%] | 0 | 4.1 | 8.2 | 12.2 | 16.3 |
| Relative Dielectric Constant | 9.7 | 8.7 | 8.9 | 8.4 | 7.7 |

Next, with reference to Table 1 and FIG. 4, the influence on the relative dielectric constant due to the change in the porosity caused by the above-described perforating is described. From the measurement results listed in Table 1 and FIG. 4, it is found that the relative dielectric constant (the real part of the complex relative dielectric constant) ε' of the sheet 21 decreases as the porosity in the disk-shaped sheet 21 (sample) increases. It should be noted that, as shown in FIG. 4, the approximate expression in the case of linearly approximating the measured value obtained by this measurement was $y = -0.1167x + 9.7$, and the determination coefficient $R^2$ (square of correlation coefficient R) in the approximate straight line (regression line) was 0.8575. The absolute value of the correlation coefficient R was made 0.9 or larger by the value of the determination coefficient $R^2$, and accordingly, it is found that there is a very strong correlation between the porosity and the relative dielectric constant ε' of each of the samples shown in FIGs. 3A to 3E, and that the deviations between the measured values plotted on the graph in FIG. 4 and the values on the approximate straight line (regression line) represented by the above-described approximate expression are small.

In the above-described example, one to four holes 4 each having a diameter of 1.4 mm were opened in the disk-shaped sheet 21 as shown in FIGs. 3B to 3E. The porosity in the disk-shaped sheet 21 was changed in this manner. However, it is found that the influence due to the change in the porosity on the relative dielectric constant is the same with the others regardless of how the holes were opened.

(Measurement of Relative Magnetic Permeability)

At the time of measurement of the relative magnetic permeability, a disk-shaped sheet 31 having a diameter (outer diameter) of 18 mm and a thickness of 1 mm shown in FIG. 5 was cut out from the above-described material sheet having a thickness of 1 mm. Then, holes 4 each having a diameter of 3 mm were opened in the disk-shaped sheet 31 with a punch for perforating in the order of 1 to 8 shown in FIG. 5. In this manner, the porosity of the disk-shaped sheet 31 was changed (increased), and the relative magnetic permeability μ' of each of the samples having the zero to eight holes 4 was measured. The measurement results are shown in Table 2 and FIG. 6. It should be noted that, as shown in FIG. 5, in the center part of the disk shaped sheet 31, a hole 32 was opened with which the disk shaped sheet 31 is attached to a jig on a side of the relative magnetic permeability measurement apparatus. The hole 32 was configured to engage with a pillar provided at the center part of the jig of the relative magnetic permeability measuring apparatus when each of the above-described samples was set in the jig. The diameter of this hole 32 was 6 mm. In addition, the reason for making the shape of each sample into disk shape (or ring shape) as described above is to reduce the influence due to the external magnetic field at the time of the measurement of the relative magnetic permeability.

TABLE 2

| Number of Holes | 0 | 1 | 2 | 3 | 4 | 5 | 6 | 7 | 8 |
|---|---|---|---|---|---|---|---|---|---|
| Porosity [vol%] | 0 | 3.1 | 6.3 | 9.4 | 12.5 | 15.6 | 18.8 | 21.9 | 25.0 |
| Relative Magnetic Permeability | 14.3 | 13.1 | 12.3 | 11.7 | 11.6 | 10.4 | 9.5 | 9.8 | 8.8 |

Next, with reference to Table 2 and FIG. 6, the influence on the relative magnetic permeability due to the change in the porosity caused by the above-described perforating is described. From the measurement results shown in Table 2 and FIG. 6, it is found that the relative magnetic permeability (the real part of the complex magnetic permeability) μ' of the disk-shaped sheet 31 decreases as the porosity in the shaped sheet 31 (sample) increases. It should be noted that, as shown in Table 2, even when the eight holes 4 were opened (when the porosity was 25.0 vol%), the relative magnetic permeability μ' of the sheet 31 was maintained at a high value of 8.8. The decrease in the relative magnetic permeability μ' of the sheet 31 is not preferable in view of suppressing electromagnetic wave, but as described above, even when the eight holes 4 were opened, the influence due to the increase in the porosity on the magnetic permeability μ' was limited. The porosities listed in Table 2 and FIG. 6 was calculated from the ratio of the volume reduced by the perforating to the volume of the original disk-shaped sheet 31 before the holes 4 open. That is, in the calculation of the porosity in this measurement, the hole 32 for attaching the disk-shaped sheet 31 to the jig shown in FIG. 5 was not regarded as a void.

In addition, as shown in FIG. 6, the approximate expression in the case of linearly approximating the measured value obtained by this measurement was y = -0.2319x + 14.3, and the determination coefficient $R^2$ (square of correlation coefficient R) in the approximate straight line (regression line) was 0.9457. The absolute value of the correlation coefficient R was made 0.9 or larger by the value of the determination coefficient $R^2$, and accordingly, it is found that there is a very strong correlation between the porosity and the relative magnetic permeability $\mu'$ of each of the samples having the zero to eight holes 4, and that the deviations between the measured values plotted on the graph in FIG. 6 and the values on the approximate straight line (regression line) represented by the above-described approximate expression are small.

In the above-described example, the porosity in the disk-shaped sheet 31 was changed by opening the one to eight holes 4 each having a diameter of 3 mm in the disk-shaped sheet 31. However, it is found that the influence due to the change in the porosity on the relative magnetic permeability is the same with the others regardless of how the holes were opened.

(Measurement of Thermal Resistance)

At the time of measurement of thermal resistance, a rectangular solid sheet 41 having a length of 25 mm, a width of 25 mm, and a thickness of 1 mm shown in FIG. 7 was cut out from the above-described material sheet having a thickness of 1 mm. Then, by opening a hole 4 with different diameters of 6 mm, 7.5 mm, 11 mm, and 13 mm in this order at the center of the rectangular solid sheet 41 (that is, increasing the diameter of the hole 4) with a punch for perforating, the porosity of the rectangular solid sheet 41 was changed (increased), and the thermal resistances of the sample when the diameter of the hole 4 was 6 mm, 7.5 mm, 11 mm, or 13 mm, in addition to the thermal resistance of the rectangular solid sheet 41 without the hole 4, were measured. Hereinafter the thermal resistance is a value representing the difficulty of transfer of temperature (heat), and means a temperature rise amount per heat value in unit time. The measurement results are shown in Table 3 and FIG. 8.

TABLE 3

| Diameter of Hole [mm] | 0 | 6 | 7.5 | 11 | 13 |
|---|---|---|---|---|---|
| Porosity [vol%] | 0 | 4.5 | 9.1 | 15.2 | 21.2 |
| Thermal Resistance [°C/W] | 0.80 | 0.83 | 0.83 | 0.90 | 0.95 |

Next, with reference to Table 3 and FIG. 8, the influence on the thermal resistance due to the change in the porosity caused by the above-described perforating is described. From the measurement results shown in Table 3 and FIG. 8, it is found that the thermal resistance of the sheet 41 increases as the porosity in the disk-shaped sheet 41 (sample) increases, but that the amount of increase in the thermal resistance is small. When the thermal resistance becomes higher, it becomes difficult to transfer heat. It is not preferable for the thermally conductive sheet. However as described above, the influence due to the increase in the porosity on the thermal resistance was small.

In addition, as shown in FIG. 8, the approximate expression in the case of linearly approximating the measured value obtained by this measurement was y = 0.0065x + 0.8, and the determination coefficient $R^2$ (square of correlation coefficient R) in the approximate straight line (regression line) was 0.9346. The absolute value of the correlation coefficient R was made 0.9 or larger by the value of the determination coefficient $R^2$, and accordingly, it is found that there is a very strong correlation between the porosity and the thermal resistance of each of the samples, and that the deviations between the measured values plotted on the graph in FIG. 8 and the values on the approximate straight line (regression line) represented by the above-described approximate expression are small.

In the above-described thermal resistance measurement, each of the samples had a length of 25 mm and a width of 25 mm as the external dimensions because a thermal resistance measuring device used for this measurement cannot accurately measure thermal resistance unless the sample has the same size with the size (a length of 25 mm and a width of 25 mm) of copper blocks for sandwiching the sample.

In the above-described example, the porosity in the rectangular solid sheet 41 was changed by opening the single hole 4 with different diameters of 6 mm, 7.5 mm, 11 mm, and 13 mm in this order at the center of the rectangular solid sheet 41 (in brief, by increasing the diameter of the hole 4 at the center). However, it is found that the influence due to the change in the porosity on the thermal resistance is the same with the others regardless of how the holes were opened.

(General Consideration on Measurement Results of Relative Dielectric Constant, Relative Magnetic Permeability, and Thermal Resistance)

Table 4 shows the rates of change in the measured values of the relative dielectric constant, the relative magnetic permeability, and the thermal resistance at the porosity of 0 vol%, and in the measured values of the relative dielectric constant, the relative magnetic permeability, and the thermal resistance at a porosity of around 15.5 vol% in a comparative manner. The rates of change were determined according to the following equation, using measured values of the relative dielectric constant, the relative magnetic permeability, and the thermal resistance at the porosity of 0 vol% as reference values.

$$\text{rate of change [\%]} = |\text{reference value - measured value}| \div \text{reference value} \times 100$$

TABLE 4

| Porosity [vol%] | | 0 | Around 15.5 |
|---|---|---|---|
| Relative Magnetic Permeability | Measured value | 14.3 | 10.4 |
| | Rate of change [%] | - | 27 |
| Relative Dielectric Constant | Measured value | 9.7 | 7.7 |
| | Rate of change [%] | - | 21 |
| Thermal Resistance | Measured value | 0.85 | 0.90 |
| | Rate of change [%] | - | 13 |

The samples used in the above-described measurements of the relative dielectric constant, the relative magnetic permeability, and the thermal resistance have different porosities, and therefore, in Table 4, the measured value of a sample the porosity of which is closest to 15.5 vol%, among the samples used for each measurement, was used to calculate the rate of change from the measured value of a sample the porosity of which is 0 vol%. As shown in Table 4, it is found that the rates of change in the relative magnetic permeability, the relative dielectric constant, and the thermal resistance were 27%, 21%, and 13%, respectively, and that even if the porosity increased, the thermal resistance was difficult to change as compared with the relative magnetic permeability and the relative dielectric constant. In addition, as shown in Table 4, the rate of change in the relative magnetic permeability was relatively large. However, it is found that the relative magnetic permeability was maintained at a high value of 10.4 even in the sample the porosity of which is closest to 15.5 vol%. As shown in Table 2, when taking into consideration that the relative magnetic permeability of the sheet 31 was maintained at a high value of 8.8 even in the sample the porosity of which is 25.0 vol%, the influence due to the increase in the porosity on the magnetic permeability was limited.

Consequently, it is found that, the increase in the porosity of a sample by opening holes in the sample can decrease the relative dielectric constant and maintain the relative magnetic permeability at a high value without significantly increasing the thermal resistance (or, without significantly decreasing the thermal property).

<MODIFIED EXAMPLES>

Modified examples of the present invention will be described below.

(Modified Example 1)

The examples of the embodiment shown above are those in which the thermally conductive composition is a thermally conductive sheet 1. However, the thermally conductive composition of the present invention is not limited to those having a sheet shape.

(Modified Example 2)

The examples described above are those in which the thermally conductive composition (thermally conductive sheet) contains a thermally conductive filler and an example in which a dielectric constant adjustment filler is used also as the thermally conductive filler are described. However, the thermally conductive composition of the present invention is not limited to these examples. For example, a high magnetic permeability filler may be used also as the thermally conductive filler, or a base material having a higher thermal conductivity than that of a normal base material (such as acrylic resin, silicone resin or the like) may be used.

## Claims

1. A thermally conductive composition (1) for promoting heat dissipation from a heat source, the thermally conductive composition (1) comprising:

   a base material (2); and
   a high magnetic permeability filler (3) having a magnetic permeability higher than that of the base material (2), wherein
   the base material (2) contains the high magnetic permeability filler (3), and
   the thermally conductive composition (1) has a relative magnetic permeability higher than 1,
   **characterized in that** the thermally conductive composition (1) further comprises an air region (4) inside the base material (2),
   the air region (4) is not perforating the base material (2), and
   the air region (4) is placed inside the base material (2) to lower a relative dielectric constant of the entire thermally conductive composition (1) to 7 or lower.

2. The thermally conductive composition (1) according to claim 1, further comprising a dielectric constant adjustment filler having a dielectric constant lower than that of the base material (2).

3. The thermally conductive composition (1) according to claim 2, wherein the dielectric constant adjustment filler comprises an in-filler air region inside or is a material selected from the group consisting of boron nitride and silica.

4. The thermally conductive composition (1) according to any one of claims 1 to 3, wherein the high magnetic permeability filler (3) has an in-filler air region inside.

## Patentansprüche

1. Wärmeleitfähige Zusammensetzung (1) zur Förderung der Wärmeableitung von einer Wärmequelle, wobei die wärmeleitfähige Zusammensetzung (1) umfasst:

   ein Basismaterial (2); und
   einen Füllstoff (3) mit hoher magnetischer Permeabilität mit einer magnetischen Permeabilität, die höher ist als die des Basismaterials (2), wobei
   das Basismaterial (2) den Füllstoff (3) mit hoher magnetischer Permeabilität enthält, und
   die wärmeleitfähige Zusammensetzung (1) eine relative magnetische Permeabilität von mehr als 1 aufweist,
   **dadurch gekennzeichnet, dass** die wärmeleitfähige Zusammensetzung (1) des Weiteren einen Luftbereich (4) im Inneren des Basismaterials (2) umfasst,
   der Luftbereich (4) das Basismaterial (2) nicht perforiert, und
   der Luftbereich (4) innerhalb des Basismaterials (2) angeordnet ist, um eine relative Dielektrizitätskonstante der gesamten wärmeleitfähigen Zusammensetzung (1) auf 7 oder niedriger zu senken.

2. Wärmeleitfähige Zusammensetzung (1) nach Anspruch 1, des Weiteren umfassend einen Füllstoff zur Einstellung der Dielektrizitätskonstante, dessen Dielektrizitätskonstante niedriger ist als die des Basismaterials (2).

3. Wärmeleitfähige Zusammensetzung (1) nach Anspruch 2, wobei der Füllstoff zur Einstellung der Dielektrizitätskonstante einen Luftbereich innerhalb des Füllstoffs umfasst oder ein Material ist, das aus der Gruppe gewählt wird, die aus Bornitrid und Siliziumdioxid besteht.

4. Wärmeleitfähige Zusammensetzung (1) nach einem der Ansprüche 1 bis 3, wobei der Füllstoff (3) mit hoher magnetischer Permeabilität einen Luftbereich innerhalb des Füllstoffs aufweist.

## Revendications

1. Composition thermoconductrice (1) pour favoriser la dissipation de la chaleur provenant d’une source de chaleur, la composition thermoconductrice (1) comprenant :

un matériau de base (2) ; et
un matériau de remplissage à haute perméabilité magnétique (3) présentant une perméabilité magnétique supérieure à celle du matériau de base (2), dans laquelle
le matériau de base (2) contient le matériau de remplissage à haute perméabilité magnétique (3), et
la composition thermoconductrice (1) présente une perméabilité magnétique relative supérieure à 1,
**caractérisée en ce que**
la composition thermoconductrice (1) comprend en outre une zone d'air (4) à l'intérieur du matériau de base (2),
la zone d'air (4) ne perfore pas le matériau de base (2), et
la zone d'air (4) est placée à l'intérieur du matériau de base (2) pour faire baisser la constante diélectrique relative de la composition thermoconductrice complète (1) à une valeur inférieure ou égale à 7.

**2.** Composition thermoconductrice (1) selon la revendication 1, comprenant en outre un matériau de remplissage d'ajustement de constante diélectrique présentant une constante diélectrique inférieure à celle du matériau de base (2).

**3.** Composition thermoconductrice (1) selon la revendication 2, dans laquelle le matériau de remplissage d'ajustement de constante diélectrique comprend une zone d'air dans le matériau de remplissage ou est un matériau sélectionné parmi le groupe constitué par le nitrure de bore et la silice.

**4.** Composition thermoconductrice (1) selon l'une quelconque des revendications 1 à 3, dans laquelle le matériau de remplissage à haute perméabilité magnétique (3) comporte une zone d'air dans le matériau de remplissage.

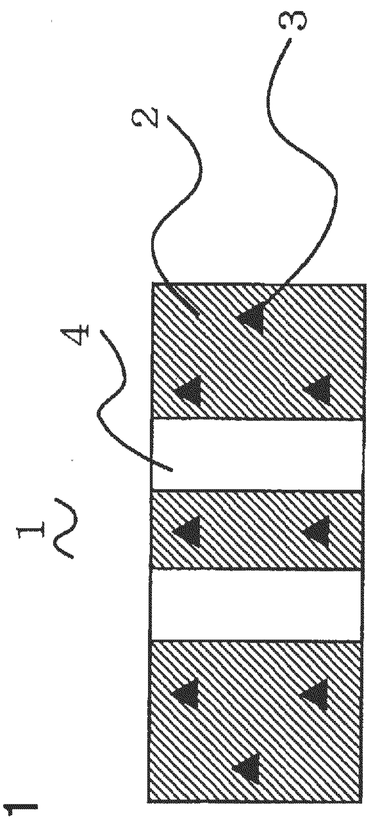


FIG. 1

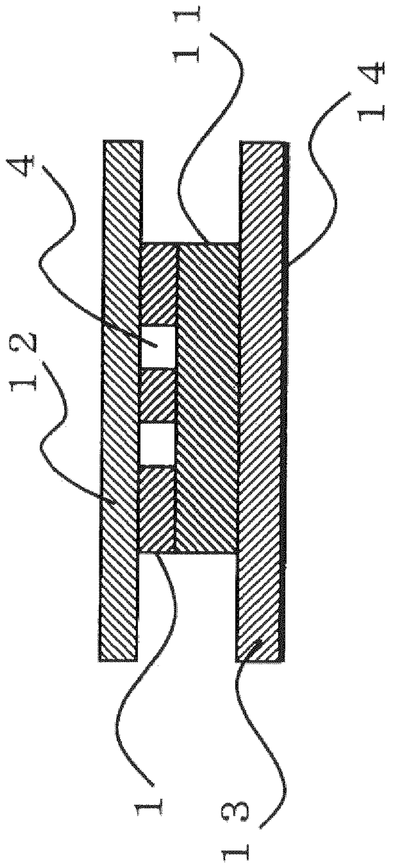


FIG. 2

FIG. 3A

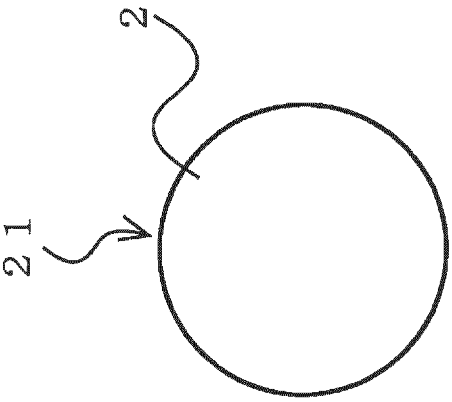


FIG. 3B

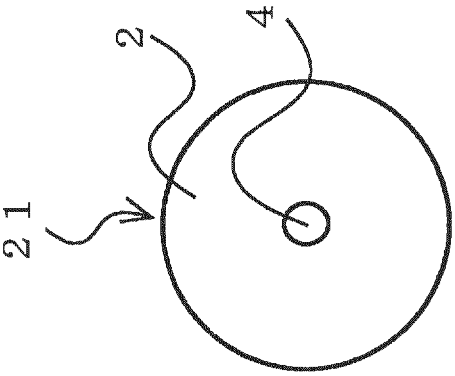


FIG. 3C

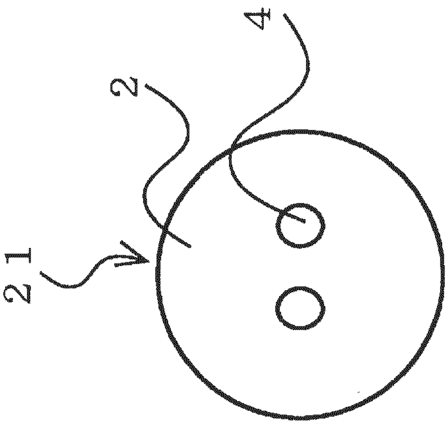


FIG. 3D

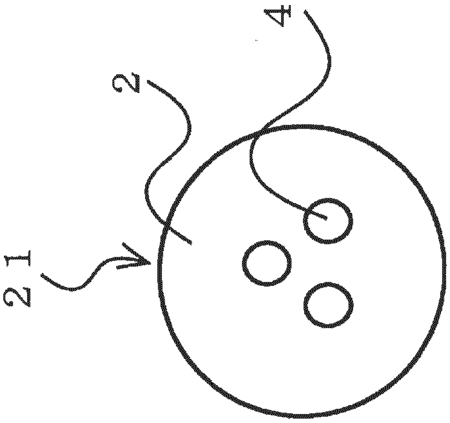


FIG. 3E

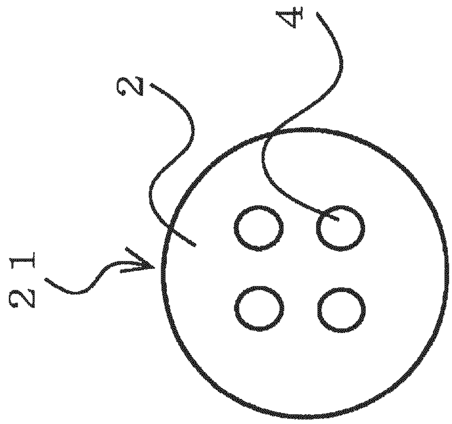

FIG. 4

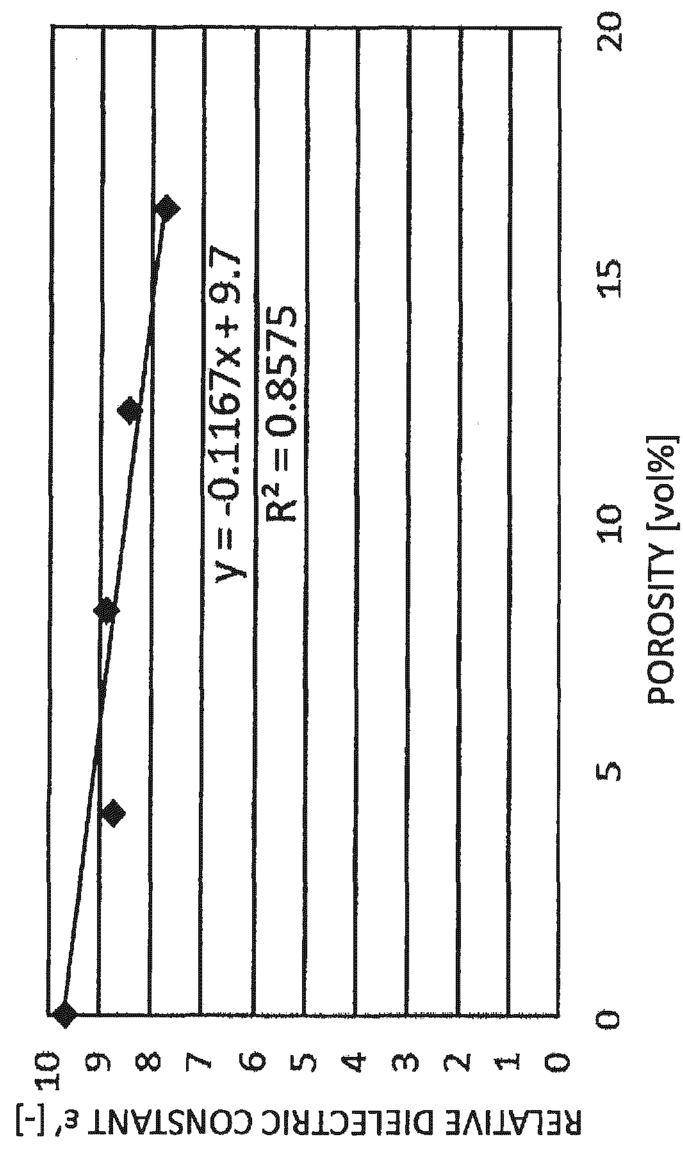

RELATIVE DIELECTRIC CONSTANT ε' [-]
POROSITY [vol%]
y = -0.1167x + 9.7
R² = 0.8575
0
1
2
3
4
5
6
7
8
9
10
15
20

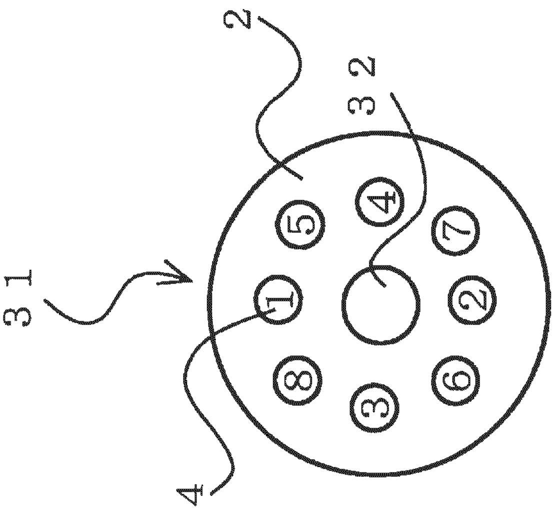


FIG. 5

FIG. 6

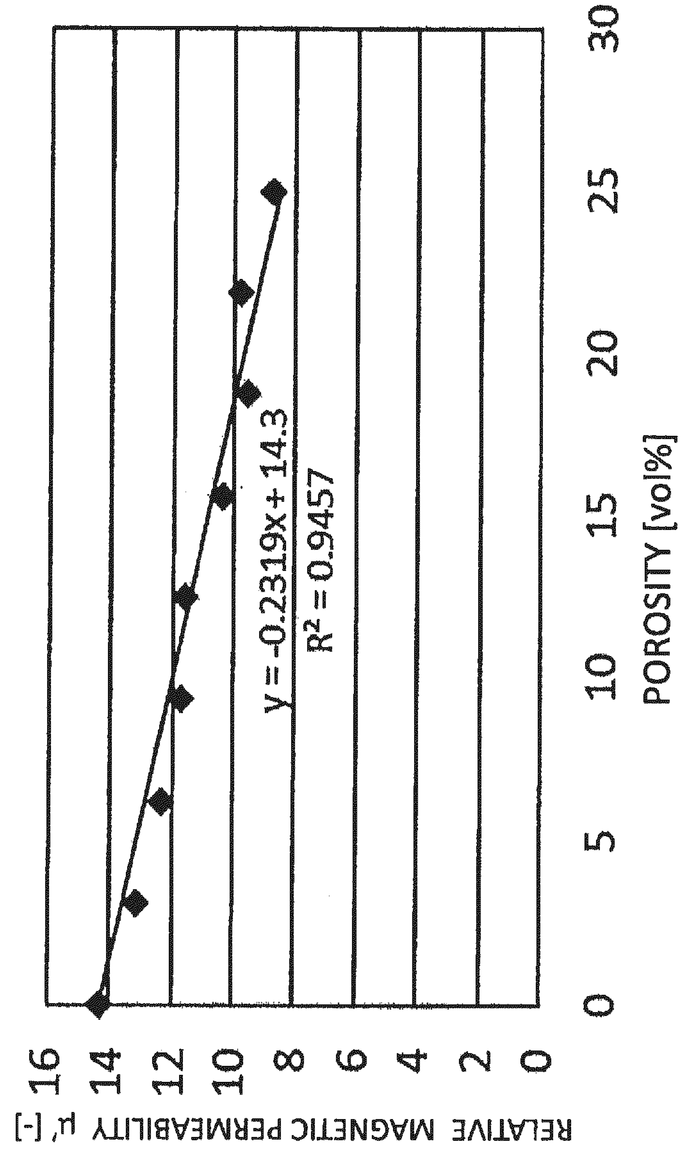

y = -0.2319x + 14.3
R² = 0.9457
RELATIVE MAGNETIC PERMEABILITY μ' [-]
POROSITY [vol%]
0
2
4
6
8
10
12
14
16
0
5
10
15
20
25
30

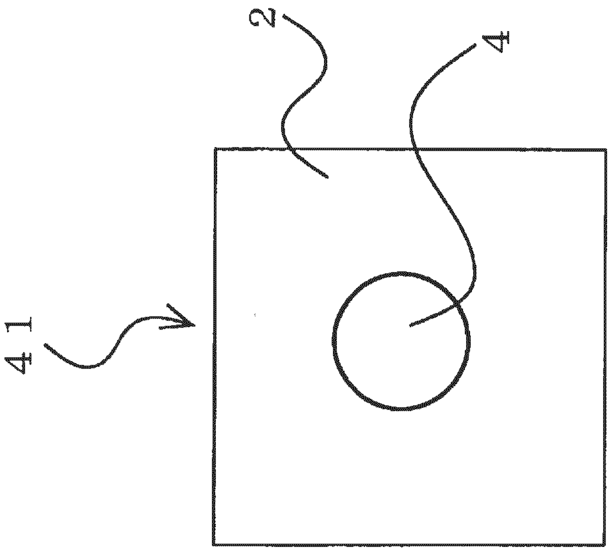


FIG. 7

FIG. 8

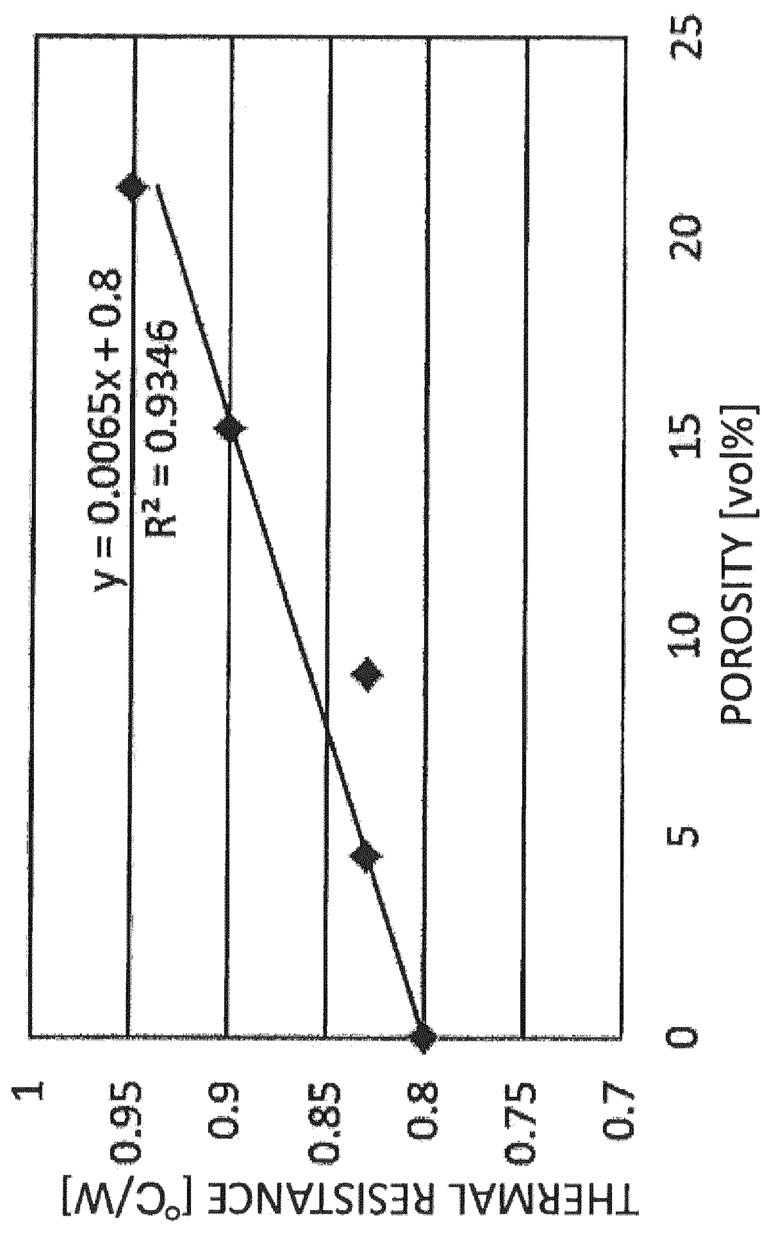
y = 0.0065x + 0.8
R² = 0.9346
THERMAL RESISTANCE [°C/W]
1
0.95
0.9
0.85
0.8
0.75
0.7
POROSITY [vol%]
0
5
10
15
20
25

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 2012228018 A1
- EP 0528606 A2
- WO 2007060746 A1
- EP 0508266 A1
- WO 2017116656 A1
- US 2017271040 A1
- JP 2016092118 A